(19) Europäisches Patentamt
European Patent Office
Office européen des brevets

(11) Publication number : **0 502 641 A1**

# (12) EUROPEAN PATENT APPLICATION

(21) Application number : **92301515.0**

(22) Date of filing : **24.02.92**

(51) Int. Cl.$^5$ : **C08L 51/00,** C08L 71/02, H05K 9/00

(30) Priority : **05.03.91 US 664764**

(43) Date of publication of application : **09.09.92 Bulletin 92/37**

(84) Designated Contracting States : **AT BE CH DE DK ES FR GB GR IT LI LU MC NL PT SE**

(71) Applicant : **NOVACOR CHEMICALS (INTERNATIONAL) S.A.**
**Fribourg, Canton of Fribourg (CH)**

(72) Inventor : **Lo, Lawrence Yun-Shin**
**61 Dexter Road**
**Lexington, Massachusetts 02173 (US)**
Inventor : **Rosato, Donald Vincent**
**40 Karen Road**
**Waban, Massachusetts 02168 (US)**

(74) Representative : **Jukes, Herbert Lewis et al**
**Swann, Elt & Company 31 Beaumont Street**
**Oxford OX1 2NP (GB)**

## (54) Electrostatic dissipative polymer alloys.

(57) The present invention relates to a blend of a graft copolymer of a styrene acrylate grafted on to a rubbery di- or tri-block copolymer, which is blend with a copolymer of an alkylene glycol with an epoxide-halogen containing monner. Such blends have a high electrostatic dissipative rate and good impact properties. Additionally the blends may be further blended with polycarbonates, polyesters, polyamides, styrenic polymers and acrylate and polyolefins. Shielding for electrical circuits and/or electrical devices, may comprise said blend(s).

EP 0 502 641 A1

The present invention relates to electrostatic dissipative polymer alloys. More specifically the present invention relates to a polymer alloy or master batch which comprises a graft copolymer and an epihalohydrin type rubber. Such master batches have good electrostatic dissipative properties. The master batch may be further compounded with other polymers e.g. polycarbonates, polyesters, polyamides styrenic polymers and acrylate polymers to produce alloys having good electrostatic dissipative properties. As used in this specification a polymer alloy which has good electrostatic dissipative properties means a polymer alloy which has a static electricity decay rate of less than 2.0, preferably less than 1.0, most preferably less than 0.5 seconds as determined by U. S. Federal Test Method Standard 101B (50 % relative humidity), or 4046 (15 % relative humidity).

Additionally, some of the polymer alloys in accordance with the present invention have excellent toughness.

Printed circuits, microchips and microprocessors are becoming more and/or devices prevalent in our society. One of the problems with such electrical circuits and or devices is that they may be disrupted or completely rendered inoperative by static electricity. There is a great concern in the electronic industry about reliability and shielding sensitive circuits from static electricity.

It is known to protect some electrical components within a polymeric casing by incorporating carbon black into the polymer matrix. This approach has a number of drawbacks. The carbon black may cause the polymer to loose ductility causing it to be subject to impact failure. The carbon black limits the coloring to Henry Ford's favourite (black). Over long periods of time the carbon may come to the surface of the polymer getting operators dirty or worse come to an inner surface of the polymer and depositing carbon particles on sensitive electrical circuits.

Carbon black may be replaced by various other doping materials such as metal fibers or flakes or oils but the problems still remain. It is desirable to develop an alloy which has inherent electrostatic dissipative properties. Furthermore, the alloy components should be compatible so the alloy will not be thermodynamically unstable. Additionally the alloy should have reasonable impact and other physical properties so that it may be handled without undue precaution. This is rather a tall order for a polymer chemist.

Borg-Warner Chemicals inc. has done some leading work in this field. United States Patent 4,588,773 issued May 13, 1986 discloses an antistatic alloy comprising ABS and epihalohydrin. European Patent Application 294 722 published 14. 12. 88 discloses an alloy comprising a styrenic polymer, epihalohydrin and an acrylate as a compatibilizer.

Neither of the above references suggests a graft copolymer of the present invention. The graft copolymer of the present invention might be characterised as an impact modified styrene acrylate. Furthermore, the references do not contemplate the potential of further blending the electrostatic dissipative alloy with other polymers. Additionally, the Izod impact of the alloys disclosed in the above references in the range from 1.5 to 3 ft.lb./in. where as with the present invention Izod impacts up to about 13 ft.lb./in. may be obtained.

United States Patent 4,680,337 issued July 14, 1987 assigned to Polysar Financial Services S.A. discloses the graft polymers of the type which are useful with the present invention. The patent does not suggest that the polymer could be useful in an electrostatic dissipative alloy.

United States Patent 4,866,125 issued September 12, 1989 discloses an alloy of polycarbonate and the graft polymer of U.S. Patent 4,866,125. The patent does not suggest that such alloys might be further modified to obtain electrostatic dissipative properties.

The present invention seeks to provide a novel electrostatic dissipative alloy.

Accordingly the present invention provides an (e.g. opaque) electrostatic dissipative polymer alloy, characterised by comprising:

(a) from 85 to 15 parts by weight of a graft copolymer comprising:

(i) from 2 to 20 parts by weight of a linear or radial di- or tri-block copolymer of the formula AB or ABA wherein A is a block polymer of one or more $C_{8-12}$ vinyl aromatic monomers which are unsubstituted or substituted by a $C_{1-4}$ alkyl radical or a chlorine atom, and B is a block or a partially hydrogenated block of one or more $C_{4-6}$ conjugated diolefins;

to which block copolymer has been grafted from 98 to 80 parts by weight of a polymer comprising:

(i) from 25 to 75 parts by weight of one or more $C_{8-12}$ vinyl aromatic monomers which are unsubstituted or substituted by a $C_{1-4}$ alkyl radical or a chlorine atom;

(ii) from 7 to 30 parts by weight of one or more copolymerizable $C_{2-8}$ alkyl or hydroxy alkyl esters of $C_{3-6}$ ethylenically unsaturated carboxylic acids provided that homopolymers of such esters have a Tg of less than 0 °C;

(iii) from 10 to 50 parts by weight of a $C_{1-2}$ alkyl acrylate or methacrylate; and

(b) from 15 to 85 parts by weight of a polymer comprising:

(i) from 20 to 80 weight % of a terminally epoxidized $C_{3-6}$ alkyl monomer which is substituted on its other end by a halogen atom; and

(ii) from 80 to 20 weight % of a $C_{2-4}$ alkylene oxide.

Electrostatic dissipative alloys of the present invention may be opaque. The graft copolymer used in the present invention is disclosed in United States Patent 4,680,337 issued July 14, 1987 the text of which is hereby incorporated by reference. The above patent also discloses processes useful to manufacture such graft polymers.

In the graft polymer the substrate is a linear or radial di- or tri-block polymer of the formulas AB or ABA. The A component in the substrate may be a block polymer of one or more $C_{8-12}$ vinyl aromatic monomers which are unsubstituted or substituted by a $C_{1-4}$ alkyl radical or a chlorine atom. The B component in the block copolymer may be a block or a partially hydrogenated block of one or more $C_{4-6}$, conjugated diolefins. If the block is hydrogenated it should be hydrogenated to at least 80 preferably at least 90 weight %. However, there should be sufficient residual unsaturation in the conjugated diolefin backbone to permit the second phase of the graft polymer to be grafted to the substrate. Preferably there should be at least 5 more preferably about 10 weight % of the residual ethylenically unsaturated bonds in the block remaining (eg. hydrogenate to not more than 95 weight % ). The block polymer substrate should have a $C_{8-12}$ vinyl aromatic monomer content of from 20 to 50 weight %. Preferably the block polymer should have a molecular weight of at least 75,000 more preferably it should have a molecular weight from 175,000 to 275,000.

Some vinyl aromatic monomers to produce the substrate are styrene, $\alpha$-methyl styrene, and t-butyl styrene. Some conjugated diolefin monomers to produce the substrate are butadiene and isoprene. Preferably the linear or radial block copolymer is selected from:

styrene-butadiene di-block copolymers, styrene-isoprene di-block copolymers, styrene-butadiene-styrene tri-block copolymers, and styrenebutadiene-styrene tri-block copolymers.

A particularly useful graft copolymer comprises:

(a) from 4 to 12 parts by weight of said di- or tri-block copolymer to which has been grafted a polymer comprising:

(i) from 30 to 65 parts by weight of said vinyl aromatic monomer;

(ii) from 8 to 20 parts by weight of said copolymerizable $C_{2-8}$ alkyl or hydroxyalkyl ester a $C_{3-6}$ ethylenically unsaturated carboxylic acid; and

(iii) from 15 to 40 parts by weight of said $C_{1-2}$ alkyl ester of acrylic or methacrylic acid, which has a Tg of greater than 20°C.

Preferably the acid in the ester of the $C_{3-6}$ ethylenically unsaturated carboxylic acid is acrylic acid. Preferably the esters of the $C_{3-6}$ ethylenically unsaturated carboxylic acid form homopolymers having a Tg of less than 20°C. Some esters are butyl acrylate, ethylhexyl acrylate, and hydroxyethyl acrylate. A preferred $C_{1-2}$ alkyl ester of acrylic or methacrylic acid is methyl methacrylate.

The second component in the alloys of the present invention (eg. component B) is a polymer comprising:

(i) from 20 to 80 preferably from 40 to 60 weight % of a terminally epoxidized $C_{3-6}$ alkyl monomer which is substituted on its other end by a halogen atom; and

(ii) from 80 to 20 preferably from 60 to 40 weight % of a $C_{2-4}$ alkylene oxide.

$C_{2-4}$ alkylene oxides may be ethylene oxide, propylene oxide and a mixture thereof. A terminally epoxidized $C_{3-6}$ alkyl monomer which is substituted on its other end by a halogen atom is epihalohydrin.

The above alloys comprise the most basic aspect of the present invention. The above alloys may be further compounded with a resin selected from:

(a) polycarbonates;

(b) polyesters;

(c) polyamides;

(d) styrenic polymers;

(e) acrylates;

(f) polyolefins.

The base alloy (eg. components A and B) may be present on an amount from 20 to 10 preferrably from 80 to 50 parts by weight and the further or additional resin may be present in an amount from about 0 to 80 preferably from 20 to 50 parts by weight.

Polycarbonates are well known and may be derived from one or more poly phenols selected from : hydroquinone, resorcinol, and poly phenols of the formula:

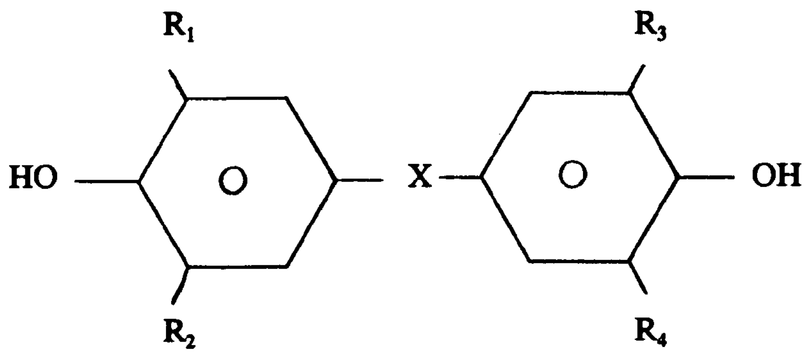

I

wherein $R_1$,$R_2$,$R_3$ and $R_4$ are independently selected from:

a hydrogen atom, a chlorine atom, a bromine atom, and a $C_{1-4}$ alkyl radical; and X is a bond or a divalent radical selected from : $C_{1-10}$ alkylene, radicals, $C_{2-8}$ alkenylene and $C_{6-8}$ cycloalklyene. Some phenol compounds are hydroquinone; resorcinol; 4,4'dihydroxydiphenyl; 2,2-bis-(4-hydroxyphenyl)propane; 2,4-bis-(4-hydroxyphenyl)-2-methylbutane; 1,1-bis-(4-hydroxyphenyl)-cyclohexane; beta, beta-bis-(4-hydroxyphenyl)p-diisopropylbenzene; 2,2-bis-(3-chloro-4-hydroxyphenyl)propane; 2,2-bis-(3,5-dichloro-4-hydroxyphenyl)propane.

The polycarbonate may be prepared by conventional methods such as melt transesterification or by the reaction of polyphenols, usually bisphenols and phosgene by a two phase boundary process.

Some polyesters may comprise aromatic polyesters or aliphatic polyesters. The polyesters may be selected from:

(a) polyesters comprising;

(i) from 50 to 80 weight % of one or more $C_{8-14}$ aromatic dicarboxylic acids or and $C_{1-4}$ alkyl esters of such acids;

(ii) from 20 to 50 weight % of one or more monomers selected from : $C_{2-10}$ alkylene glycols and $C_{6-10}$ cyclic glycols; and

(iii) from 0 to 10 weight % of one or more copolymerizable $C_{5-10}$ aliphatic dicarboxylic acids; and

(b) polyesters comprising:

(i) from 50 to 80 weight % of one or more monomers selected from : $C_{3-8}$ ethylenically unsaturated dicarboxylic acids and $C_{2-10}$ aliphatic dicarboxylic acids; and

(ii) from 20 to 50 weight % of one or more monomers selected from : $C_{2-10}$ alkylene glycols and $C_{5-10}$ aliphatic dicarboxylic acids.

Some $C_{8-14}$ aromatic dicarboxylic acids are terephthalic acid and isophthalic acid. A $C_{1-4}$ alkyl ester of such acids may be dimethylterephthalic acid (DMT). Some $C_{6-10}$ alkylene glycols are ethylene glycol and butylene glycol. The preferred aromatic polyesters are polyethylene terephthalate (PET) and polybutylene terephthalate (PBT). However, if desired a small amount of $C_{6-10}$ cyclic glycol may be included in the above preferred esters to yield the PETG type esters.

The alloys of the present invention may comprise a polyamide. The polyamides in accordance with the present invention may be any commercially available polyamide (commonly called nylon). The polyamide may be a polymer of one or more $C_{4-8}$ lactams, a copolymer of one or more $C_{4-8}$ alkyl diamines copolymerized with one or more $C_{4-12}$ saturated dicarboxylic acids or a polymer of one or more $C_{4-12}$ amino-carboxylic acids. A $C_{4-8}$ lactam is caprolactam which when polymerized gives rise to nylon 6. $C_{4-12}$ alkane diamines include hexamethylene diamine. A $C_{4-12}$ saturated dicarboxylic acid is adipic acid. The copolymerization of these latter two compounds gives rise to nylon 66. A $C_{4-12}$ amino-carbosylic acid is omega-aminoundecanoic acid which when homopolymerized gives rise to nylon 11.

The alloys of the present invention may include styrenic polymers. The styrenic polymer may be selected from :

(a) homopolymers of one or more $C_{8-12}$ vinyl aromatic monomers which are unsubstituted or substitutes by a $C_{1-4}$ alkyl radical or a chlorine atom;

(b) copolymers comprising:

(i) from 20 to 80 parts by weight of one or more $C_{8-12}$ vinyl aromatic monomers which are unsubstituted or substituted by a $C_{1-4}$ alkyl radical or a chlorine atom;

(ii) from 80 to 20 parts by weight of one or more monomers selected from : $C_{3-6}$ alkenyl nitriles, and

$C_{1-4}$ alkyl and hydroxyalkyl esters of acrylic and methacrylic acid;
which polymers may be grafted onto from 0 to 40 parts by weight of a polymer comprising:
(i) from 100 to 60 parts by weight of a $C_{4-6}$ conjugated diolefin; and
(ii) from 0 to 40 parts by weight of one or more $C_{8-12}$ vinyl aromatic monomers which are unsubstituted or substituted by a $C_{1-4}$ alkyl radical or a chlorine atom; and
(c) copolymers comprising:
(i) from 99.5 to 80 weight % of one or more $C_{8-12}$ vinyl aromatic monomers which are unsubstituted or substituted by a $C_{1-4}$ alkyl radical or a chlorine atom; and
(ii) from 0.5 to 20 weight % of one or more anhydrides of $C_{4-6}$ ethylenically unsaturated dicarboxylic acids.

Some vinyl aromatic monomers have been discussed above. Some $C_{3-6}$ alkenyl nitriles are acrylonitrile and methacrylonitrile. Some $C_{1-4}$ alkyl and hydroxyalkyl esters of acrylic and methacrylic acid are methyl methacrylate, ethyl methacrylate, methyl acrylate, ethyl acrylate and hydroxyethyl acrylate. An anhydride of $C_{4-6}$ ethylenically unsaturated dicarboxylic acids may be maleic anhydride.

As noted above the styrenic polymer may be grafted onto a substrate polymer. The substrate polymer may be a $C_{4-6}$ conjugated diolefin homopolymer or a copolymer of the conjugated diolefin and a vinyl aromatic monomer. Some conjugated diolefins and vinyl aromatic monomers have been discussed above.

Polystyrene, styrene acrylonitrile (SAN), acrylonitrile butadiene styrene (ABS) and styrene maleic anhydride (SMA) polymers are particularly useful styrenic polymers.

The alloys of the present invention may include an acrylic resin comprising:
(i) from 100 to 15 parts by weight of a $C_{1-4}$ alkyl or hydroxyalkyl ester of acrylic or methacrylic acid;
(ii) fom 0 to 85 parts by weight of a $C_{8-12}$ vinyl aromatic monomer which is unsubstituted or substituted by a $C_{1-4}$ alkyl radical or a chlorine atom;
(iii) from 0 to 5 parts by weight of a $C_{3-6}$ ethylenically unsaturated carboxylic acid;
which polymer may be grafted onto from 0 to 40 parts by weight of a polymer selected from :
(a) polymers comprising:
(i) from 100 to 60 weight % of one or more $C_{4-6}$ alkyl or hydroxy alkyl acrylates or methacrylates; and
(ii) from 0 to 40 weight % of one or more monomers selected from: $C_{1-12}$ alkyl acrylates or methacrylates, and $C_{8-12}$ vinyl aromatic monomers which are unsubstituted or substituted by a $C_{1-4}$ alkyl radical or a chlorine atom; and
(b) polymers comprising:
(i) from 100 to 60 weight % of one or more $C_{4-6}$ conjugated diolefins which are unsubstituted or substituted by a chlorine atom; and
(ii) from 0 to 40 weight 5% of one or more monomers selected from : $C_{1-2}$ acrylates or methacrylates, and $C_{8-12}$ vinyl aromatic monomers which are unsubstituted or substituted by a $C_{1-4}$ alkyl radical or a chlorine atom.

$C_{1-4}$ alkyl and hydroxy alkyl esters of acrylic and methacrylic acid have been discussed above. Some vinyl aromatic monomers have been discussed above. Some $C_{3-6}$ ethylenically unsaturated acids are acrylic acid, methacrylic acid, itaconic acid and fumaric acid. Some $C_{4-8}$ alkyl or hydroxyalkyl esters of acrylic and methacrylic acid have been discussed above and may be those esters which form homopolymers having a Tg of less than -20°C. Some $C_{4-6}$ conjugated diolefins have been discussed above.

If the acrylic polymer is a graft copolymer a particularly useful substrate is poly butyl acrylate onto which is grafted a polymer of one or more monomers selected from : methyl methacrylate, ethyl methacrylate, methyl acrylate, ethyl acrylate and hydroxyethyl acrylate.

The alloys of the present invention may comprise a homopolymer or a copolymer of one or more alpha-olefins or a terpolymer of two alpha-olefins and a nonconjugated diene e.g. an EPDM. Some alpha-olefins are $C_{2-4}$ alpha-olefins e.g. ethylene, propylene and butylene. A nonconjugated diene monomer is 5-ethylidene-2-norbornene. In the case of copolymers the rubber would be an EPR and the terpolymer would be an EPDM rubber.

Both the styrenic and acrylic polymers may be prepared by known processes including bulk polymerization, solution polymerization and suspension polymerization. The polyester may be prepared using conventional processes for formation of the ester and then solid-stating the polymer to the higher molecular weight. After preparation the polymers are usually cooled and chopped to resin pellets. Generally it is desirable to purchase the polymers in pellet form.

If the blend comprises a polymer which requires drying such as polycarbonates, polyesters or

polyamides,the polymer should be dried before use. The drying conditions for the polymers are well known to those skilled in the art. Typically the drying conditions range from about 60 to 120°C for from about 3 to 24 hours.

Generally it is desirable to prepare a master batch of the graft copolymer and the polymer of the terminally epoxidized $C_{3-6}$ alkyl monomer which has a halogen atom on its other end and the $C_{2-4}$ alkylene oxide. The weight ratio of the blend has been discussed above. The polymers may be dry blended in a suitable blender such as a tumble blender and then fed to an extruder. The extruder may be a single or preferably a twin screw extruder. The extruder may be operated at from 50 to 300 preferably 100 to 200 most preferably from 120 to 170 RPM's. The extruder may be operated at barrel temperatures from about 180 to 300 preferably 190 to 240°C.

It should also be borne in mind that the polymer alloy may be prepared by solution blending provided that the components are soluble in a common solvent. The technique of solution blending is also known in the art. The selection of the specific solvent and conditions would involve routine non-inventive development.

The present invention will now be illustrated by the following examples in which unless otherwise indicated parts are parts by weight and % is weight %.

## Example 1

A graft copolymer comprising about 40% styrene, 50% of a mixture of lower alkyl acrylates and methyl methacrylate grafted onto 10 % of a styrenebutadiene tri-block polymer having a molecular weight from 175,000 to 275,000 was prepared in accordance with the teachings of U.S. Patent 4,680,337 issued July 14, 1987.

The graft copolymer was dry blended with a copolymer of ethylene oxide and epichlorohydrin in a weight ratio of about 50:50 sold under the trade mark HYDRIN C in a weight ratio of graft copolymer: HYDRIN C of 80:20. The dry blend was then melt blended in a co-rotating twin screw extruder operating at about 120 RPM and at a barrel zone (five zones) temperatures of 190 to 240°C. The melt was extruded as strands which were cooled and chopped to pellets.

The resulting pellets were molded into suitable test specimens and tested for IZOD impact using ASTM procedure D-256 and for surface resistivity using ASTM D-257.

The polymer alloy had an IZOD impact strength of about 10 ft.lb./in/ and a surface resistivity of $10^{12}$ ohms/sq.

In Table II of European Patent Application 294,722 the IZOD impact strength of the alloys of epichlorohydrin, polymethylmethacrylate and the styrenic polymer (HIPS) is in the 2.5 to about 3 ft.lb./in range. The alloy of EP 294,722 also had good color properties. The blends of the graft copolymer and the epihalohydrin polymer of the present invention have similar electrostatic properties to those of E.P. 294,722 and superior impact properties. Additionally, the blends of the present invention have eliminated one essential feature of E.P. 294,722, namely the acrylic polymer.

## Example 2

The graft copolymer of example 1 was blended with the epichlorohydrin-ethylene oxide copolymer of example 1 and a dried commercially available polycarbonate sold under the trademark LEXAN 141, in a weight ratio of 40:20:40 were melt blended, and pelletized as described in example 1. Samples of the resulting resin were injection molded. The molded samples were then tested for their properties using the following test methods:

(a) Izod Impact (ft.lb./in.) - ASTM D - 256;

(b) Tensile Strength (psi) - ASTM D - 638;

(c) Surface Resistivity (ohms/sq.) ASTM D - 257; and

(d) Static Decay rate (sec.) U.S. Federal Test Method Standard 101B (50 % relative humidity), or 4046 (15 % relative humidity).

The results of the testing together with literature values for various blends of styrene maleic anhydride (SMA), polypropylene (PP) with epichlorohydrin polymer sold under the trademark STAT RITE® is reported in Table II together with representative data from EP 294,722.

## TABLE II

| Polymer | Graft Copolymer | SMA/STAT RITE | PP/STAT RITE | EP 294,722 |
|---|---|---|---|---|
| - | HYDRIN C | STAT RITE | STAT RITE | - |
| - | Poly-carbonate | - | - | - |
| - | 40:20:40 | 80:20 | 80:20 | - |
| IZOD | 13 | 2.5 | 9 | 2-3 |
| Tensile | 3850 | 3500 | 2000 | 3000-3300 |
| Resistivity | $10^{12}$ | $10^{12}$ | $10^{13}$ | $10^{12}$ |
| Decay Rate | 0.23 | 0.18 | 1.2 | 1.24 |

These data show that blends of the present invention have a superior range of properties over material currently available.

In the present application's disclosure of the present invention, any numerical value includes the precise value and any value "about" or "essentially" or "substantially" the same as the precise value. The wording of the appended claims and abstract is incorporated into the present description. The words "essential" and "essentially" may be precise values or values substantially the same as the precise values, etc. The word "opaque" also includes "essentially opaque" or "substantially opaque", etc.

### Claims

1. An (e.g. opaque) electrostatic dissipative polymer alloy comprising:
   (a) from 85 to 15 parts by weight of a graft copolymer comprising;
   (i) from 2 to 20 parts by weight of a linear or radial di- or tri-block copolymer of the formula AB or ABA wherein A is a block polymer of one or more $C_{8-12}$ vinyl aromatic monomers which are unsubstituted or substituted by a $C_{1-4}$ alkyl radical or a chlorine atom, and B is a block or a partially hydrogenated block of one or more $C_{4-6}$ conjugated diolefins;
   to which block copolymer has been grafted from 98 to 80 parts by weight of a polymer comprising:
   (i) from 25 to 75 parts by weight of one or more $C_{8-12}$ vinyl aromatic monomers which are unsubstituted or substituted by a $C_{1-4}$ alkyl radical or a chlorine atom;
   (ii) from 7 to 30 parts by weight of one or more copolymerizable $C_{2-8}$ alkyl or hydroxy alkyl esters of $C_{3-6}$ ethylenically unsaturated carboxylic acids provided that homopolymers of such esters have a Tg of less than 0°C; and
   (iii) from 10 to 50 parts by weight of a $C_{1-2}$ alkyl acrylate or methacrylate;
   (b) from 15 to 85 parts by weight of a polymer comprising:
   (i) from 20 to 80 weight % of a terminally epoxidized $C_{3-6}$ alkyl monomer which is substituted on its other end by a halogen atom; and
   (ii) from 80 to 20 weight % of a $C_{2-4}$ alkylene oxide.

2. The polymer alloy according to claim 1, characterized by in component A said di- or tri-block copolymer has a molecular weight of not less than 75,000.

3. The polymer alloy according to claim 2, characterized by in component A said di- or tri-block copolymer has a molecular weight form 175,000 to 275,000.

4. The polymer alloy according to claim 3, characterized by in component A said di- or tri-block copolymer has a $C_{8-12}$ vinyl aromatic monomer content of from 20 to 50 weight %.

5. The polymer alloy according to claim 4, characterized by in component A said vinyl aromatic monomer is selected from : styrene, α-methyl styrene, and t-butyl styrene.

6. The polymer alloy according to claim 5, characterized by in component A said conjugated diolefin is selected from : butadiene and isoprene.

7. The polymer alloy according to claim 6, characterized by said linear- or radial-block copolymer is selected from ; styrene-butadiene di-block copolymers, styrene-isoprene di-block copolymers, styrene-butadienestyrene tri-block copolymers, and styrene-butadiene-styrene tri-block copolymers.

8. The polymer alloy according to claim 7, characterized by component A comprises:
   (a) from 4 to 12 parts by weight of said di- or tri-block copolymer to which has been grafted a polymer comprising:
      (i) from 30 to 65 parts by weight of said vinyl aromatic monomer;
      (ii) from 8 to 20 parts by weight of said copolymerizable $C_{2-8}$ alkyl or hydroxyalkyl ester a $C_{3-6}$ ethylenically unsaturated carboxylic acid; and
      (iii) from 15 to 40 parts by weight of said $C_{1-2}$ alkyl ester of acrylic or methacrylic acid, which has a Tg of greater than 20°C.

9. The polymer according to claim 8, characterized by in component A said $C_{3-6}$ ethylenically unsaturated carboxylic acid is acrylic acid.

10. The polymer alloy according to claim 9, characterized by in component A said $C_{2-8}$ alkyl or hydroxy alkyl ester of a $C_{3-6}$ ethylenically unsaturated carboxylic acid forms a homopolymer having a Tg of less than -20°C.

11. The polymer alloy according to claim 10, characterized by in component A said $C_{2-8}$ alkyl or hydroxy alkyl ester of a $C_{3-6}$ unsaturated carboxylic acid is selected from : butyl acrylate, ethylhexyl acrylate and hydroxyethyl acrylate.

12. The polymer alloy according to claim 11, characterized by in component A said $C_{1-2}$ alkyl ester of acrylic or methacrylic acid is methyl methacrylate.

13. The polymer alloy according to claim 12, characterized by in component B said terminally epoxidized $C_{3-6}$ alkyl monomer which is substituted on its other end by a halogen atom is present in an amount form 40 to 60 weight % and said $C_{2-4}$ alkylene oxide is present in an amount from 60 to 40 weight %.

14. The polymer alloy according to claim 13, characterized by in component B said $C_{2-4}$ alkylene oxide is selected from : ethylene oxide, propylene oxide and a mixture thereof.

15. The polymer alloy according to claim 14,/ said terminally epoxidized $C_{3-6}$ alkyl monomer which is substituted on its other end by a halogen atom is epihalohydrin.

16. The polymer alloy according to claim 15,/comprising per 20 to 100 parts by combined weight of components A and B from 0 to 80 parts by weight of a further resin selected from :
   (a) polycarbonates;
   (b) polyesters;
   (c) polyamides;
   (d) styrenic polymers;
   (e) acrylates; and
   (f) polyolefins.

17. The polymer alloy according to claim 16, characterized by comprising from 80 to 50 parts by combined weight of components A and B from 20 to 50 parts by weight of a further resin selected from :
   (a) polycarbonates;
   (b) polyesters;

(c) polyamides;
(d) styrenic polymers;
(e) acrylates; and
(f) polyolefins.

**18.** The polymer alloy according to claim 16, characterized by said polycarbonate is derived from one or more phenol compounds selected from : of hydroquinone, resorcinol, 4,4′dihydroxydiphenyl; 2,2-bis-(4-hydroxyphenyl)propane; 2,4-bis-(4-hydroxyphenyl)-2-methylbutane; 1,1-bis:(4-hydroxyphenyl)-cyclohexane; beta,beta-bis-(4-hydroxyphenyl)p-diisopropylbenzene; 2,2-bis-(3-chloro-4-hydroxyphenyl)propane; 2,2-bis-(3,5-dichloro-4-hydroxyphenyl)propane.

**19.** The polymer alloy according to claim 17, characterized by said polycarbonate is derived from one or more phenol compounds selected from : of hydroquinone, resorcinol, 4,4′dihydroxydiphenyl; 2,2-bis-(4-hydroxyphenyl)propane; 2,4-bis-(4-hydroxyphenyl)-2-methylbutane; 1,1-bis-(4-hydroxyphenyl)-cyclohexane; beta,beta-bis-(4-hydroxyphenyl)p-diisopropylbenzene; 2,2-bis-(3-chloro-4-hydroxyphenyl)propane;2,2-bis-(3,5-dichloro-4-hydroxyphenyl)propane.

**20.** The polymer alloy according to claim 16, characterized by said polyamide is selected from :
polymers of $C_{4-8}$ lactams, copolymers of one or more $C_{4-12}$ alkyl diamines copolymerized with one or more $C_{4-12}$ saturated dicarboxylic acids or a polymer of one or more $C_{4-12}$ amino-carboxylic acids.

**21.** The polymer alloy according to claim 17, characterized by said polyamide is selected from : polymers of $C_{4-8}$ lactams, copolymers of one or more $C_{4-12}$ alkyl diamines copolymerized with one or more $C_{4-12}$ saturated dicarboxylic acids or a polymer of one or more $C_{4-12}$ amino-carboxylic acids.

**22.** The polymer alloy according to claim 16, characterized by said styrenic polymer is selected from :
(a) homopolymers of one or more $C_{8-12}$ vinyl aromatic monomers which are unsubstituted or substitutes by a $C_{1-4}$ alkyl radical or a chlorine atom;
(b) copolymers comprising:
(i) from 20 to 80 parts by weight of one or more $C_{8-12}$ vinyl aromatic monomers which are unsubstituted or substituted by a $C_{1-4}$ alkyl radical or a chlorine atom;
(ii) from 80 to 20 parts by weight of one or more monomers selected from : $C_{3-6}$ alkenyl nitriles, and $C_{1-4}$ alkyl and hydroxyalkyl esters of acrylic and methacrylic acid;
which polymers may be grafted onto from 0 to 40 parts by weight of a polymer comprising:
(i) from 100 to 60 parts by weight of a $C_{4-6}$ conjugated diolefin;
(ii) from 0 to 40 parts by weight of one or more $C_{8-12}$ vinyl aromatic monomers which are unsubstituted or substituted by a $C_{1-4}$ alkyl radical or a chlorine atom; and
(c) copolymers comprising:
(i) from 99.5 to 80 weight % of one or more $C_{8-12}$ vinyl aromatic monomers which are unsubstituted or substituted by a $C_{1-4}$ alkyl radical or a chlorine atom; and
(ii) from 0.5 to 20 weight % of one or more anhydrides of $C_{4-8}$ unsaturated dicarboxylic acids.

**23.** The polymer alloy according to claim 17, characterised by said styrenic polymer is selected from :
(a) homopolymers of one or more $C_{8-12}$ vinyl aromatic monomers which are unsubstituted or substitutes by a $C_{1-4}$ alkyl radical or a chlorine atom;
(b) copolymers comprising:
(i) from 20 to 80 parts by weight of one or more $C_{8-12}$ vinyl aromatic monomers which are unsubstituted or substituted by a $C_{1-4}$ alkyl radical or a chlorine atom;
(ii) from 80 to 20 parts by weight of one or more monomers selected from : $C_{3-6}$ alkenyl nitriles, and $C_{1-4}$ alkyl and hydroxyalkyl esters of acrylic and methacrylic acid;
which polymers may be grafted onto from 0 to 40 parts by weight of a polymer comprising:
(i) from 10 to 60 parts by weight of a $C_{4-6}$ conjugated diolefin;
(ii) from 0 to 40 parts by weight of one or more $C_{8-12}$ vinyl aromatic monomers which are unsubstituted or substituted by a $C_{1-4}$ alkyl radical or a chlorine atom; and
(c) copolymers comprising:
(i) from 99.5 to 80 weight % of one or more $C_{8-12}$ vinyl aromatic monomers which arte unsubstituted

or substituted by a $C_{1-4}$ alkyl radical or a chlorine atom; and
(ii) from 0.5 to 20 weight % of one or more anhydrides of $C_{4-6}$ unsaturated carboxylic acids.

**24.** The polymer alloy according to claim 22, characterized by said styrenic polymer is selected from : polystyrene, styrene acrylonitrile, acrylonitrile butadiene styrene and styrene maleic anhydride polymer.

**25.** The polymer alloy according to claim 23, characterized by wherein said styrenic polymer is selected from : polystyrene, styrene acrylonitrile, acrylonitrile butadiene styrene and styrene maleic anhydride polymer.

**26.** The polymer alloy according to claim 16, characterized by said acrylic comprises:
(i) from 100 to 20 parts by weight of a $C_{1-4}$ alkyl or hydroxyalkyl ester of acrylic or methacrylic acid;
(ii) from 0 to 80 parts by weight of a $C_{8-12}$ vinyl aromatic monomer which is unsubstituted or substituted by a $C_{1-4}$ alkyl radical or a chlorine atom;
(iii) from 0 to 5 parts by weight of a $C_{3-6}$ ethylenically unsaturated carboxylic acid;
which polymer may be grafted onto from 0 to 40 parts by weight of a polymer selected from :
(a) polymers comprising:
(i) from 100 to 60 weight % of one or more $C_{4-8}$ alkyl or hydroxy alkyl acrylates or methacrylates; and
(ii) from 0 to 40 weight % of one or more monomers selected from: $C_{1-2}$ alkyl acrylates or methacrylates, and $C_{8-12}$ vinyl aromatic monomers which are unsubstituted or substituted by a $C_{1-4}$ alkyl radical or a chlorine atom; and
(b) polymers comprising:
(i) from 100 to 60 weight % of one or more $C_{4-6}$ conjugated diolefins which are unsubstituted or substituted by a chlorine atom; and
(ii) from 0 to 40 weight 5 % of one or more monomers selected from ; $C_{1-2}$ alkyl acrylates or methacrylates, and $C_{8-12}$ vinyl aromatic monomers which are unsubstituted or substituted by a $C_{1-4}$ alkyl radical or a chlorine atom.

**27.** The polymer alloy according to claim 17, characterized by acrylic comprises:
(i) from 100 to 20 parts by weight of a $C_{1-4}$ alkyl or hydroxyalkyl ester of acrylic or methacrylic acid;
(ii) from 0 to 80 % by weight of a $C_{8-12}$ vinyl aromatic monomer which is unsubstituted or substituted by a $C_{1-4}$ radical or a chlorine atom;
(iii) from 0 to 5 parts by weight of a $C_{3-6}$ ethylenically unsaturated carboxylic acid;
which polymer may be grafted onto from 0 to 40 parts by weight of a polymer selected from :
(a) polymers comprising:
(i) from 100 to 60 weight % of one or more $C_{4-8}$ alkyl or hydroxy alkyl acrylates or methacrylates; and
(ii) from 0 to 40 weight % of one or more monomers selected from: $C_{1-2}$ alkyl acrylates or methacrylates, and $C_{8-12}$ vinyl aromatic monomers which are unsubstituted or substituted by a $C_{1-4}$ alkyl radical or a chlorine atom; and
(b) polymers comprising:
(i) from 100 to 60 weight % of one or more $C_{4-6}$ conjugated diolefins which are unsubstituted or substituted by a chlorine atom; and (ii) from 0 to 40 weight 5 % of one or more monomers selected from : $C_{1-2}$ alkyl acrylates or methacrylates, and $C_{8-12}$ vinyl aromatic monomers which are unsubstituted or substituted by a $C_{1-4}$ alkyl radical or a chlorine atom.

**28.** The polymer alloy according to claim 16, characterized by said polyester is selected from :
(a) polyesters comprising;
(i) from 50 to 80 weight % of one or more $C_{8-14}$ aromatic dicarboxylic acids or and $C_{1-4}$ alkyl esters of such acids;
(ii) from 20 to 50 weight % of one or more monomers selected from : $C_{2-10}$ alkylene glycols and $C_{6-10}$ cyclic glycols; and
(iii) from 0 to 10 weight % of one or more copolymerisable $C_{5-10}$ aliphatic dicarboxylic acids; and
(b) polyesters comprising;
(i) from 50 to 80 weight % of one or more monomers selected from : $C_{3-8}$ ethylenically unsaturated dicarboxylic acids and $C_{2-10}$ aliphatic dicarboxylic acids; and

(ii) from 20 to 50 weight % of one or more monomers selected from : $C_{2-10}$ alkylene glycols and $C_{5-10}$ aliphatic dicarboxylic acids.

**29.** The polymer alloy according to claim 17, characterized by said polyester is selected from ;
(a) polyesters comprising;
(i) from 50 to 80 weight % of one or more $C_{8-14}$ aromatic dicarboxylic acids or and $C_{1-4}$ alkyl esters of such acids;
(ii) from 20 to 50 weight % of one or more monomers selected from : $C_{2-10}$ alkylene glycols and $C_{6-10}$ cyclic glycols; and
(iii) from 0 to 10 weight % of one or more copolymerisable $C_{5-10}$ aliphatic dicarboxylic acids; and
(b) polyesters comprising:
(i) from 50 to 80 weight % of one or more monomers selected from : $C_{3-8}$ ethylenically unsaturated dicarboxylic acids and $C_{2-10}$ aliphatic dicarboxylic acids; and
(ii) from 20 to 50 weight % of one or more monomers selected from : $C_{2-10}$ alkylene glycols and $C_{5-10}$ aliphatic dicarboxylic acids.

**30.** The polymer alloy according to claim 28, characterized by said polyester is selected from : polyethylene terephthalate and polybutylene terephthalate.

**31.** The polymer alloy according to claim 29, characterized by said polyester is selected from : polyethylene terephthalate and polybutylene terephthalate.

**32.** The polymer alloy according to claim 16, characterized by said polyolefin is a poly $C_{2-4}$ alpha-olefin.

**33.** The polymer alloy according to claim 17,characterized by said polyolefin is a poly $C_{2-4}$ alpha-olefin.

**34.** The polymer alloy according to claim 32, characterized by said polyolefin is selected from: homo and copolymoers of ethylene, propylene and butylene.

**35.** The polymer alloy according to claim 33, characterized by said polyolefin is selected from : homo and copolymers of ethylene, propylene and butylene.

**36.** The polymer alloy according to claim 32, characterized by said polyolefin is an EPDM.

**37.** The polymer according to claim 33, characterized by said polyolefin is an EPDM.

**38.** A blend of a graft copolymer, characterized by a styrene acrylate grafted on to a rubbery di- or tri-block copolymer, which is blended with a copolymer of an alkylene glycol with an epoxide-halogen containing monomer.

**39.** Shielding for electrical circuits and/or electrical devices, characterised by comprising electrostatic dissipative alloy(s) according to any one of claims 1 to 37, and/or by comprising blend(s) according claim 38.

European Patent Office

# EUROPEAN SEARCH REPORT

Application Number

EP 92 30 1515

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | WORLD PATENTS INDEX LATEST<br>Derwent Publications Ltd., London, GB;<br>AN 90-380887<br>& JP-A-2 276 853 (TOYOBO KK) 13 November 1990<br>* abstract *<br>--- | 1,5-7,16 | C08L51/00<br>C08L71/02<br>H05K9/00 |
| D,A | EP-A-0 294 722 (GE CHEMICALS, INC.)<br>* claims *<br>----- | 1,5-6,16 | |
| | | | **TECHNICAL FIELDS SEARCHED (Int. Cl.5 )** |
| | | | C08L |

The present search report has been drawn up for all claims

| Place of search | Date of completion of the search | Examiner |
|---|---|---|
| THE HAGUE | 22 JUNE 1992 | FUHR C.K.B. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)